Europäisches Patentamt

European Patent Office

Office européen des brevets

(11) Publication number: **0 343 872**
**A2**

## (12) EUROPEAN PATENT APPLICATION

(21) Application number: **89305098.9**

(51) Int. Cl.⁴: **H03K 17/22**

(22) Date of filing: **19.05.89**

(30) Priority: **27.05.88 US 199444**

(43) Date of publication of application:
**29.11.89 Bulletin 89/48**

(84) Designated Contracting States:
**AT BE CH DE ES FR GB GR IT LI LU NL SE**

(71) Applicant: **ADVANCED MICRO DEVICES, INC.**
**901 Thompson Place P.O. Box 3453**
**Sunnyvale, CA 94088(US)**

(72) Inventor: **Schnizlein, Paul G.**
**6806 Edinburgh**
**Austin, TX 78749(US)**

(74) Representative: **Wright, Hugh Ronald et al**
**Brookes & Martin 52/54 High Holborn**
**London WC1V 6SE(GB)**

(54) CMOS power-on reset circuit.

(57) A CMOS power-on reset circuit which turns off a reset signal applied to logic circuits only after a power supply voltage reaches a predetermined level when powered up from an inactive state includes a voltage detector stage and a RC delay stage. The voltage detector stage (16) is formed of a first P-channel transistor (P1), a second P-channel transistor (P2), and a first capacitor (C1). The delay stage (18) is formed of a third P-channel transistor (P3) and a second capacitor (C2). The voltage detector stage is used to measure the voltage level of the power supply voltage and generates a control signal. The delay stage is responsive to the power supply voltage and the control signal for inhibiting turn-off of a reset signal at an output node until after the power supply voltage has reached a predetermined level. Logic circuits (14) are provided which respond to the power supply voltage and the reset signal to control logic operations.

EP 0 343 872 A2

## CMOS POWER-ON RESET CIRCUIT

### BACKGROUND OF THE INVENTION

This invention relates generally to CMOS integrated circuits and more particularly, it relates to a CMOS power-on reset circuit which turns off a reset signal applied to logic circuits only after the power supply voltage reaches a certain level when powered up from an inactive or off state.

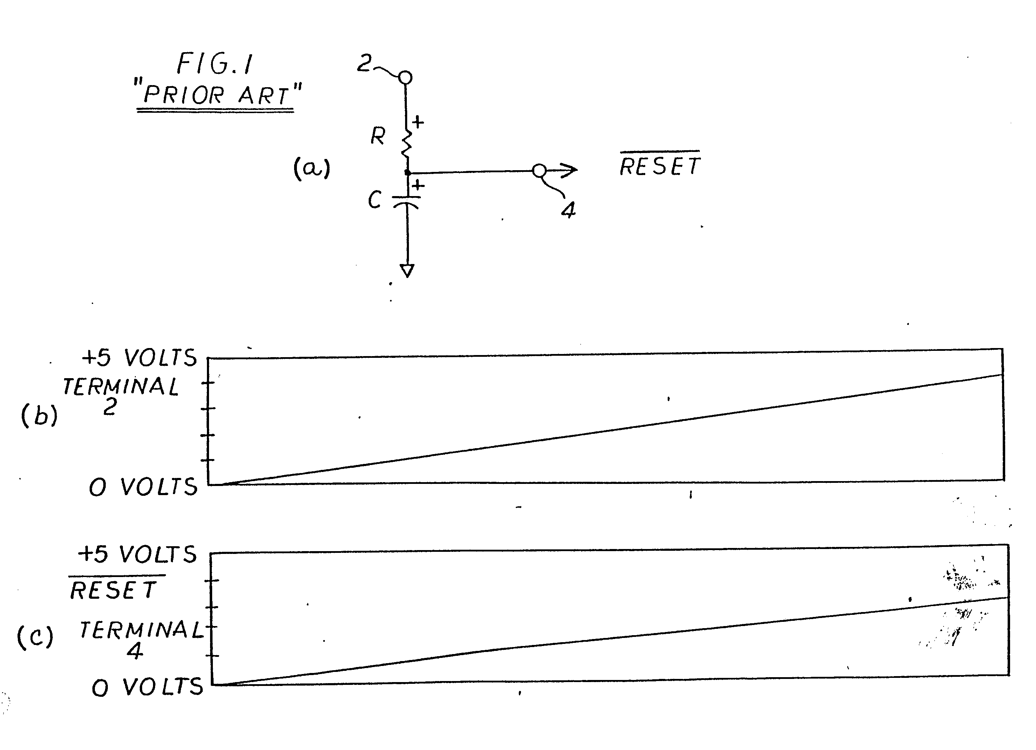

As is generally known, a reset signal is commonly applied to set or render outputs of logic and/or memory circuits to a particular known logic state after power has been applied. Presently, a simple RC reset circuit is implemented using a series-connected resistor and capacitor, as shown in Figure 1a and labeled "Prior-Art." This prior art reset circuit suffers from the problem of failing to reset properly the logic and/or memory circuits when the rise time of the power supply voltage is too long as compared to the RC time constant. As a result, the reset signal on its output terminal 4 will not be delayed with respect to the rising supply voltage VCC at the power supply terminal 2. The waveforms at the power supply terminal 2 and the output terminal 4 are shown in Figures 1b and 1c, respectively. Thus, the reset signal may be turned off or removed from the logic circuits prior to the time when the power supply voltage is sufficiently high enough to operate reliably the logic circuits. This is because the points at which the logic states switch between the high and low levels may be dependent upon the value of the applied power supply voltage that is being powered up.

It would therefore be desirable to provide a CMOS power-on reset circuit which turns off a reset signal applied to logic circuits only after the power supply voltage reaches a predetermined level when powered up from an inactive state. The reset circuit of the present invention is formed of a voltage detection stage and a RC delay stage. The voltage detection stage is used to measure the voltage level of the power supply voltage and generates a control signal. The delay stage is responsive to the power supply voltage and the control signal for inhibiting turn-off of a reset signal at an output node until after the power supply voltage has reached a predetermined level. Logic circuits are operatively connected to the power supply voltage and the reset signal to control logic operations.

We will describe a CMOS power-on reset circuit which is relatively simple and economical to manufacture and assemble, but overcomes the problem encountered in the prior art reset circuits.

We will describe a CMOS power-on reset circuit which turns off the reset signal applied to logic circuits only after the power supply voltage reaches a predetermined level.

We will describe a CMOS power-on reset circuit which includes a voltage detection stage and a RC delay stage.

We will describe a CMOS power-on reset circuit which is formed as a part of the same monolithic semiconductor integrated circuit chip containing logic and/or memory circuits.

The present invention provides a CMOS power-on reset circuit which turns off a reset signal applied to logic circuits only after a power supply voltage reaches a predetermined level when powered up from an inactive state, said circuit comprising in combination:
a power supply terminal for receiving a power supply voltage;
a voltage detector means responsive to said power supply voltage for measuring the voltage level of said power supply voltage and for generating a control signal;
delay means responsive to said power supply voltage and said control signal for inhibiting turn-off of a reset signal at an output node until after the power supply voltage has reached a predetermined level; and
logic means responsive to said power supply voltage and said reset signal for controlling logic operations.

### BRIEF DESCRIPTION OF THE DRAWINGS

These and other objects and advantages of the present invention will become more fully apparent from the following detailed description when read in conjunction with the accompanying drawings with like reference numerals indicating corresponding parts throughout, wherein:

Figure 1a shows a prior art reset circuit;

Figures 1b and 1c are waveforms at the respective terminals 2 and 4 of the reset circuit shown in Figure 1a;

Figure 2 is a schematic circuit diagram of a CMOS power-on reset circuit according to the present invention; and

Figures 3(a)-3(c) are waveforms at various points in the circuit of Figure 2, which are useful in understanding the operation thereof.

## DESCRIPTION OF THE PREFERRED EMBODIMENT

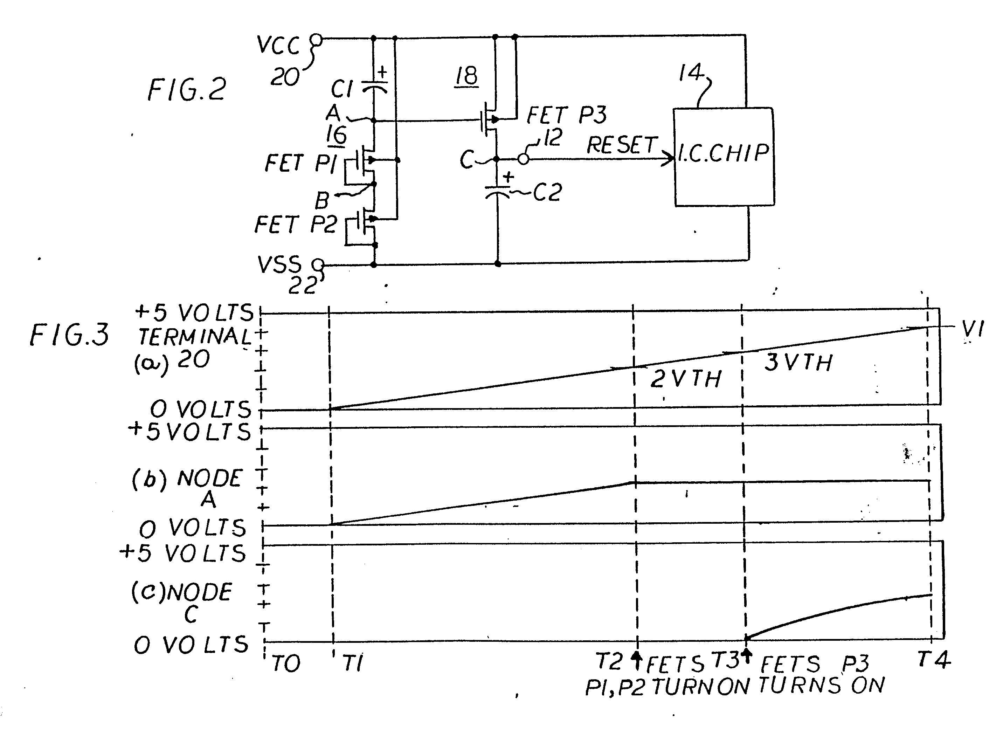

Referring now in detail to the drawings, there is shown in Figure 2 a schematic circuit diagram of a CMOS power-on reset circuit 10 constructed in accordance with the principles of the present invention. The reset circuit 10 provides a reset signal $\overline{RESET}$ on its output terminal 12 which is coupled to a monolithic semiconductor integrated circuit chip 14 containing various logic and/or memory circuits (not shown). The reset signal $\overline{RESET}$ is a logic signal and initiates a reset to the integrated circuit chip 14 when it is at a low logic level. The reset is turned off or removed from the integrated circuit chip 14 when the reset signal $\overline{RESET}$ is at a high logic level.

The reset circuit 10 includes a voltage detector stage 16 and a RC delay stage 18. The voltage detector stage 16 is comprised of a first P-channel field-effect transistor (FET) P1, a second P-channel FET P2, and a first capacitor C1. The P-channel transistor P1 has its source electrode connected to one end of the first capacitor C1 and to a node A. The other end of first capacitor C1 is connected to a first power supply terminal 20 for receiving a power supply voltage or potential VCC. The gate and drain electrodes of the P-channel transistor P1 are connected together and to a node B. The gate and drain electrodes of the P-channel transistor P2 are connected together and to a second power supply terminal 22 for receiving a power supply voltage or potential VSS (which may be at ground potential or zero volts).

When the reset circuit 10 is powered up from an inactive or off state, the power supply potential VCC will ramp up to the steady-state level of approximately +5.0 volts. The first capacitor C1 is preferably implemented as a gate oxide capacitance of an N-channel field-effect transistor. Typically, the gate electrode of the N-channel transistor forms one plate of the capacitor, and the gate and drain electrodes are tied together to form the other plate of the capacitor.

The RC delay stage 18 is comprised of a third P-channel FET P3 and a second capacitor C2. The third P-channel transistor P3 has its gate electrode connected to the node A, its source electrode connected to the first power supply terminal 20, and its drain connected to an output node C. The output node C provides the reset signal $\overline{RESET}$ to the output terminal 12. The output node C is also connected to one end of the second capacitor C2, and the other end of the second capacitor C2 is connected to the second power supply terminal 22. The integrated circuit chip 14 is also connected to the first power supply terminal 20.

In order to provide an understanding of the operation of the reset circuit 10 of the present invention, reference is now made to Figure 3(a)-3-(c) of the drawings which illustrate waveforms appearing at various points in the reset circuit of Figure 2. Initially, it is assumed that the power supply voltage VCC applied to the first power supply terminal 20 is in the turned-off condition or inactive state. As a result, all of the P-channel transistors P1, P2 and P3 are turned off, and the capacitors C1 and C2 are uncharged at the time t0. The power supply voltage VCC is shown in Figure 3(a). Consequently, the nodes A and C are at a low or logic "0" level (VSS), as is illustrated in respective Figures 3(b) and 3(c). Since the reset signal $\overline{RESET}$ is taken from the node C, it will be at the low level which maintains a reset condition on the logic circuits in the integrated circuit chip 14.

When the power supply voltage VCC is powered up or turned on at the time t1, the voltage level at the first power supply terminal 20 will begin to ramp up. Since the first capacitor C1 acts as a short initially to the change in the power supply voltage VCC, the voltage level at the node A will follow the rising power supply voltage. It should be noted that the transistors P1 and P2 will remain turned off until the time t2 when the voltage level at the node A begins to exceed the sum of the threshold voltages $V_{TH(P1)}$ and $V_{TH(P2)}$ of the respective transistors P1 and P2. At the time t2, the transistors P1 and P2 will be rendered conductive so that the node A will be maintained at approximately $2V_{TH}$ while the power supply voltage VCC continues to rise thereafter.

As can be seen from Figure 3(c), the node C is still at the voltage level of VSS at the time t2 since the transistor P3 is non-conductive. At the time t3, the power supply voltage level has risen to $3V_{TH}$. Thereafter, the difference between the source and gate of the transistor P3 will be greater than one threshold voltage $V_{TH}$ ($3V_{TH}$ - $2V_{TH}$) so as to cause the transistor P3 to go into conduction. After the time t3, the second capacitor C3 will begin to charge and the node C will rise from the voltage VSS towards the power supply voltage VCC.

At some time t4, the reset signal $\overline{RESET}$ at the node C will be at a level corresponding to a high or logic "1" level so as to remove or disconnect the reset applied to the logic circuits on the integrated circuit chip 14. However, at such time t4, the power supply voltage VCC applied to the logic circuits will have already reached the predetermined level of V1, which is sufficiently high enough so as to insure reliable operation of the logic circuits.

It should be appreciated that the voltage detection stage 16 of the present reset circuit 10 it utilized to measure the voltage level of the power supply voltage VCC as it is powered up and inhibits the operation of the RC delay stage 18 until a certain power supply voltage level is reached. As a result, the reset signal will be continued to be applied to the logic circuits. When the predetermined power supply voltage level is reached which insures proper operation of the logic circuits, the RC delay stage 18 is allowed to operate so as to create a delay and then turns off the reset signal. In other words, the reset signal at the node C is delayed with respect to the rising power supply voltage VCC. Thus, the reset signal is inhibited from being turned off until after the power supply voltage has reached a predetermined level, thereby avoiding inproper operation of the logic circuits.

As should be clear to those skilled in the art, if a higher power supply voltage level was required for reliable operation of the logic circuits the number of series-connected P-channel transistors in the voltage detector stage could be increased. It should also be apparent that the P-channel transistors could be replaced by N-channel transistors so as to form an alternative embodiment. Further, the reset circuit 10 may be formed as a part of the same integrated circuit chip 14 containing the logic and/or memory circuits, thereby saving board components and eliminates the need for an extra package pin.

From the foregoing detailed description, it can thus be seen that the present invention provides a CMOS power-on reset circuit which turns off a reset signal applied to logic circuits only after the power supply voltage reaches a predetermined level when powered up from an inactive state. The reset circuit is formed of a voltage detector stage and a RC delay stage. Further, the reset circuit may be formed as a part of the same integrated circuit chip containing the logic circuits.

While there has been illustrated and described what is at present considered to be a preferred embodiment of the present invention, it will be understood by those skilled in the art that various changes and modifications may be made, and equivalents may be substituted for elements thereof without departing from the true scope of the invention. In addition, many modifications may be made to adapt a particular situation or material to the teachings of the invention without departing from the central scope thereof. Therefore, it is intended that this invention not be limited to the particular embodiment disclosed as the best mode contemplated for carrying out the invention, but that the invention will include all embodiments falling within the scope of the appended claims.

## Claims

1. A CMOS power-on reset circuit which turns off a reset signal applied to logic circuits only after a power supply voltage reaches a predetermined level when powered up from an inactive state, said circuit comprising in combination:

a power supply terminal (20) for receiving a power supply voltage (VCC);

voltage detector means (16) responsive to said power supply voltage (VCC) for measuring the voltage level of said power supply voltage (VCC) and for generating a control signal;

delay means (18) responsive to said power supply voltage (VCC) and said control signal for inhibiting turn-off of a reset signal at an output node until after the power supply voltage (VCC) has reached a predetermined level; and

logic means (14) responsive to said power supply voltage (VCC) and said reset signal for controlling logic operations.

2. A reset circuit as claimed in Claim 1, wherein said voltage detector means (16) includes a first P-channel transistor (P1), a second P-channel transistor (P2), and a first capacitor (C1).

3. A reset circuit as claimed in Claim 2, wherein said first P-channel transistor has its source connected to one end of said first capacitor (C1) and to an internal node to provide said control signal, the other end of said capacitor (C1) being connected to the power supply terminal (20), said first P-channel transistor (P1) having its gate and drain connected together and to the source of said second P-channel transistor (P2), said second P-channel transistor (P2) having its gate and drain connected together and to a ground potential (VSS).

4. A reset circuit as claimed in Claim 1, wherein said delay means (18) includes a P-channel transistor (P3) and a capacitor (C2).

5. A reset circuit as claimed in Claim 4, wherein said P-channel transistor (P3) has its source connected to the power supply terminal (20), its gate connected to an internal node, and its drain connected to one end of the capacitor (C2) and to the output node to provide said reset signal, the other end of said capacitor (C2) being connected to a ground potential (VSS).

6. A reset circuit as claimed in Claim 5, wherein said logic means (14) comprises logic and/or memory circuits formed on a single monolithic semiconductor integrated circuit chip.

7. A reset circuit as claimed in Claim 6, wherein said reset circuit is formed as a part of the same integrated circuit chip containing the logic and/or memory circuits.

8. A reset circuit as claimed in Claim 1, wherein said logic means (14) comprises logic and/or memory circuits formed on a single monolithic semiconductor integrated circuit chip.

9. A reset circuit as claimed in Claim 8, wherein said reset circuit is formed as a part of the same integrated circuit chip containing the logic and/or memory circuits.

10. A CMOS power-on reset circuit which turns off a reset signal applied to logic circuit only after a power supply voltage reaches a predetermined level when powered up from an inactive state, said circuit comprising, in combination:

a power supply terminal (20) for receiving a power supply voltage (VCC);

a voltage detector stage (16) formed of a first P-channel transistor (P1), a second P-channel transistor (P2), and a first capacitor (C1), and providing a control signal;

said first P-channel transistor (P1) having its source connected to one end of said first capacitor (C1) and to an internal node to provide said control signal, the other end of said capacitor (C1) being connected to the power supply terminal (20), said first P-channel transistor (P1) having its gate and drain connected together and to the source of said second P-channel transistor (P2), said second P-channel transistor (P2) having its gate and drain connected together and to a ground potential (VSS);

a RC delay stage (18) formed of a third P-channel transistor (P3) and a second capacitor (C2) and providing a reset signal at an output node;

said third P-channel transistor (P3) having its source connected to the power supply terminal (20), its gate connected to the internal node, and its drain connected to one end of the second capacitor (C2) and to the output node to provide said reset signal, the other end of said capacitor (C2) being connected to the ground potential (VSS); and

logic circuits (14) operatively connected to the power supply voltage and said reset signal and being responsive thereto.

11. A reset circuit as claimed in Claim 10, wherein said logic means (14) comprises logic and/or memory circuits formed on a single monolithic semiconductor integrated circuit chip.

12. A reset circuit as claimed in Claim 11, wherein said reset circuit is formed as a part of the same integrated circuit chip containing the logic and/or memory circuits.

EP 0 343 872 A2

FIG.1
"PRIOR ART"

(a)

R

C

$\overline{RESET}$

2

4

(b)

+5 VOLTS
TERMINAL
2

O VOLTS

(c)

+5 VOLTS
$\overline{RESET}$
TERMINAL
4

O VOLTS

FIG.2

VCC ○
20

CI ≑⁺
A
16
FET PI

B

FET P2

VSS ○
22

18

FET P3

12
C   ○   RESET → I.C.CHIP

C2 ≑⁺

14

FIG.3

(a) TERMINAL 20

+5 VOLTS

O VOLTS

VI

2VTH   3VTH

(b) NODE A

+5 VOLTS

O VOLTS

(c) NODE C

+5 VOLTS

O VOLTS

TO   TI           T2 ↑FETS T3↑ FETS P3   T4
                  PI,P2 TURN ON  TURNS ON